# EUROPEAN PATENT SPECIFICATION

(11) **EP 0 678 902 B1**
(45) Date of publication and mention of the grant of the patent: **29.05.1996**
(21) Application number: 94830194.0
(22) Date of filing: 22.04.1994
(51) Int. Cl.: H01L 21/00

(54) **Manual holding device for wafer-carrier baskets**
Manuelle Haltevorrichtung für Scheiben-Träger Behälter
Dispositif de maintien manuel pour panier porteur de galette

(43) Date of publication of application: 25.10.1995
(73) Proprietor: SGS-THOMSON MICROELECTRONICS S.r.l., I-20041 Agrate Brianza (Milano) (IT)
(72) Inventor: Gervasoni, Natale, I-20040 Caponago, Milano (IT)
(74) Representative: Maggioni, Claudio

(56) References cited:
- US-A- 3 466 079
- US-A- 4 743 156
- Robotic Wafer Handling Equipment, RECIF SA, June 1993

## Description

The present invention relates to tools for transporting slices of semiconductor material being processed in plants for producing electronic semiconductor devices and, more particularly, to a manual holding device for slice-carrier baskets of the type known for example from page 5 of a catalog, dated June 1993 on "Robotic wafer handling equipment" of the firm RECIF S.A. and as defined in the preamble of claim 1.

As is known, the active part of electronic semiconductor devices consists of a chip which is obtained, together with numerous similar chips, from a slice of semiconductor material, typically monocrystalline silicon, subjected to a series of different physical-chemical processes. The slices are substantially circular with a diameter which, in the majority of current operations, is approximately 15 cm (6") and are between 0.5 and 0.7 mm thick.

For the various operations and for the transfer between different operating stations, the slices are loaded onto containers, conventionally known as baskets, such as known from US-A-4 743 156, in which they are disposed, parallel and separate, each in a seat in which it is supported solely by the edges. The baskets are made of various materials depending on the intended use: for example, of quartz for high-temperature processes, of Teflon for processes in chemical baths, and of polypropylene for transfer and storage. The present invention relates substantially to these two latter types of basket.

As is known, when the slices of semiconductor material are processed, maximum attention is essential for avoiding small extraneous particles of any type being deposited on the slices. Various arrangements are provided for this purpose, such as filtering the air from the surroundings in which the processes are performed, picking up the slices with vacuum or pressurized devices, as known for example from US-A-3 466 079 and handling the slices and the respective containers with forceps and gloves. In many cases, the baskets are handled directly with gloved hands. However, it has been noted that the gloves are carriers of various types of particles, including those of the material from which the gloves themselves are made, some of which material is deposited on the slices. In order to reduce the extent of this contamination, manual holding devices have been proposed for grasping and transporting the baskets without bringing the hands too close to the slices. However, the devices proposed have been shown to be not very practical or not very reliable for various reasons: for example, since they do not permit rapid engaging which is at the same time secure, since they restrict the possible movements merely to a horizontal translation of the basket, since they have parts made of materials which are likely to be oxidised or attacked by acids, or with materials which can become electrostatically charged and therefore likely to induce charges in the slices, that is, as is known, in certain cases they can damage the electronic devices formed thereon.

The general object of the present invention is to provide a manual holding device for containers of slices of semiconductor material which enables the above disadvantages to be overcome and which, in particular, is practical, reliable and permits any movement of the basket to which it is applied.

This object is achieved by providing a device as defined and characterised in the first of the claims following the present description.

The invention and the resultant advantages will become clearer from the following description of an embodiment thereof which is nevertheless non-limiting, given in relation to the appended drawings, in which:
- Figures 1 and 2 show in perspective a basket and a holding device according to the invention, respectively, with the device before and after being coupled to the basket; and
- Figure 3 is a perspective view of the holding device according to the invention from another view point.

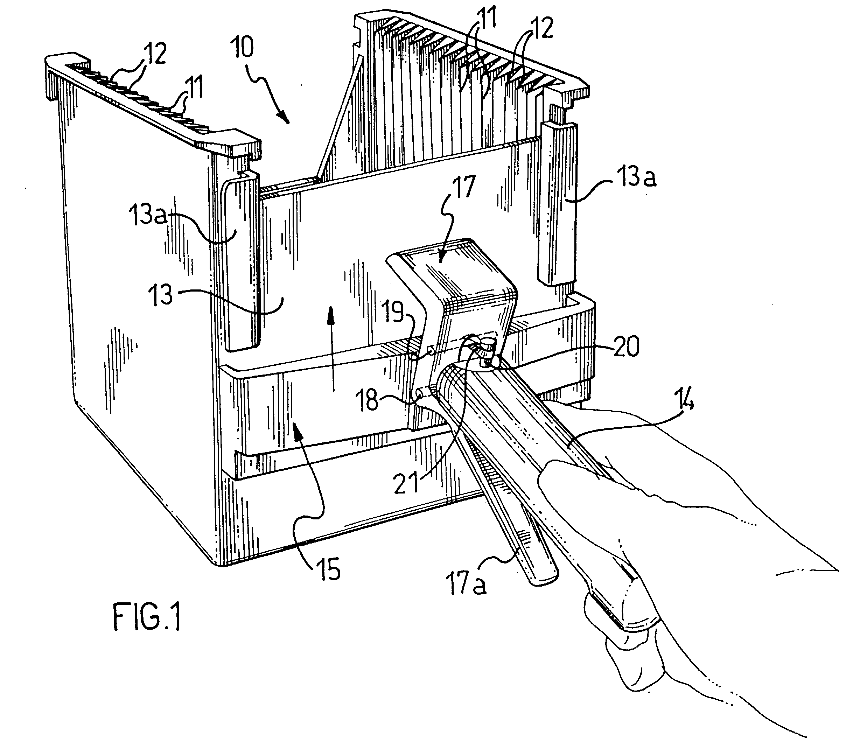

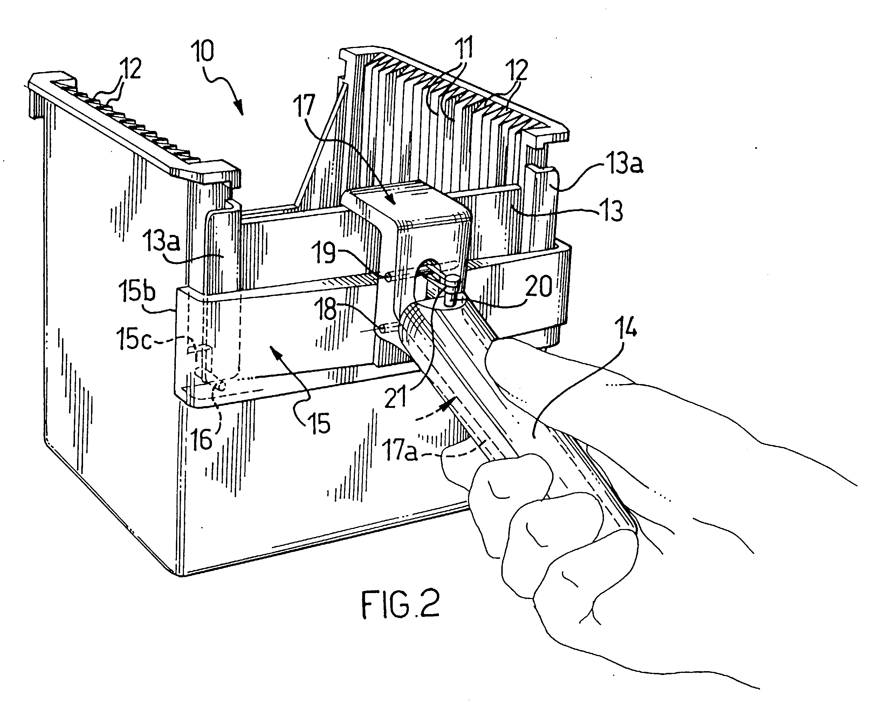

The basket shown in Figures 1 and 2, generally indicated 10, is of the type made of polypropylene used for the transfer and storage of the slices. It consists of a substantially box-like container with an open side having two opposite walls shaped with parallel ribs 11 which delimit between them seats 12 for the slices. The slices, not shown, having a diameter which is slightly smaller than the internal width of the basket, are each placed in a seat 12 and are held in position by ribs 11 such that they are parallel to and separate from one another. One of the container walls adjacent the ribbed walls and indicated 13 is substantially flat and has two projections 13a which extend approximately half-way along two opposite sides. The upper side of the wall 13, that is the one facing the opening for the introduction of the slices, is straight.

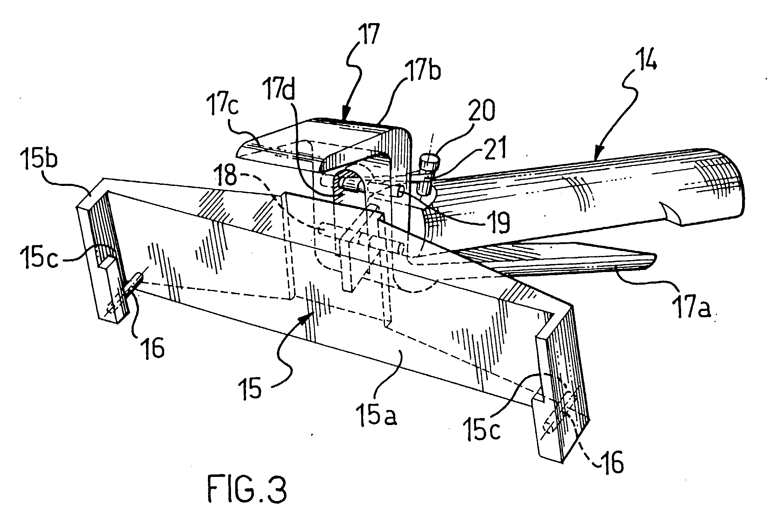

The holding device according to the invention consists of two main parts connected so as to be articulated relative to one another: a handle and holding part and a locking part. The handle and holding part is, in turn, formed of two parts, that is a rod-like handle 14 and a support element 15 of elongate shape which is rigidly secured to the handle at its central part. This element 15 is shaped so as to have a flat support surface 15a (Figure 3) and two opposite ends 15b which are folded at a right-angle relative to the flat surface 15a and, for part of their length, are folded back towards the interior so as to form two parallel grooves 15c. The grooves form a sliding seat for the corresponding projections 13a of the walls 13 of the basket 10 and are closed at their lower ends by respective locking pins 16 secured to the support element 15. The two grooves 15c and the two locking pins 16 constitute means for retaining the projections 13a and, therefore, efficient coupling means between the holding device and the walls 13 of the basket.

The locking part consists of a lever 17 resting on a fulcrum in a part connecting the handle and the support element 15 by means of a pin 18. The lever has an arm 17a which extends towards the handle and constitutes a means of actuating the holding device, and an arm 17b which is folded at an angle so as to form a locking tooth 17c. The arm 17b has an opening 17d through which the above-mentioned connection part extends. A pin 19 passes through the arm in correspondence with the opening. A resilient ring 21 the function of which is to hold the lever in the rest position, that is, with the locking tooth 17c disengaged, is stretched between the pin 19 and a pin 20 secured at one end of the handle.

Advantageously, both the handle and holding part and the locking part are made of anti-static material, that is with good electrostatic charge-dissipation properties, such as the plastics materials known by the abbreviations PVDF and PEEK, which are also resistant to acids. Both the pins 18 and 19, the pin 20 and the resilient ring 21 are made of materials which are resistant to corrosion.

In order to couple the above-mentioned holding device to a basket, the flat internal surface 15a of the support element 15 is brought into contact with the lower surface of the wall 13 of the basket, as shown in Figure 1, then the support 15 is raised by means of the handle 14, causing it to slide such that the projections 13 engage the grooves 15c until they contact the locking pins 16 and, finally, the arm 17a of the lever 17 is pulled towards the handle against the return action of the resilient ring 21. By this movement, the locking tooth 17c is situated against the upper side of the wall 13, such that the holding device is locked in position, as shown in Figure 2, and the basket can be raised, moved and oriented in all directions, according to requirements, with the maximum degree of safety and using only one hand.

Advantageously, the longitudinal axis of the handle is inclined slightly downwards, that is, in the opposite direction to the open side of the basket 10, so as to assist both the handling of the device when the latter is engaged with the basket in the horizontal position and when it is engaged with the basket in the vertical position (position for insertion in a tank for chemical etching).

In order to disengage the holding device from the basket, it is sufficient to release the arm 17a of the lever and, after placing the basket on a support surface, or after placing it in the base of a box which can be closed and is suitably shaped for containing the basket, to slide the support element downwards so as to release the grooves 15c from the projections 13a of the wall 13.

## Claims

1. A manual holding device for a container of slices of semiconductor material comprising a handle and holding part (14, 15) having means for coupling (15, 15c) to a wall (13) of the container (10), characterized in that said coupling means (15,15c) comprises a locking part (17), connected in articulated manner to the handle and holding part (14, 15) and comprising locking means (17c) and manual actuating means (17a) for bringing the locking means (17c) into engagement with the container (13), it being possible for these actuating means (17a) to be actuated with the same hand which is holding the handle (14).

2. A device according to Claim 1, for a container (10) having a substantially flat wall (13) with projections (13a) on two opposite sides, in which the coupling means (15, 15c) have two opposite ends having retention means (15b, 15c) which can engage the projections (13a) of the wall (13) of the container.

3. A device according to Claim 2, in which the retention means (15b, 15c) each comprise a groove (15c) which constitutes a sliding seat for the corresponding projection (13a) of the wall of the container.

4. A device according to Claim 3, in which the retention means (15b, 15c) each comprise locking means (16) which restrict the sliding of the projections (13a) in the respective grooves (15c).

5. A device according to any one of Claims 2 to 4, in which the handle and holding part (14, 15) consists of a support element (15) comprising the above-mentioned coupling means (15c) and of a rod-like handle (14) which is integral with the support element (15) and projects from a central zone thereof and in which the locking means (17c) are disposed at the end of one of the two arms (17b) of a lever (17) resting on a fulcrum between the handle (14) and the support element (15) and in which the actuating means consist of the other (17a) of the two arms of the lever (17), this other arm (17a) extending towards the handle (14) so as to be able to be carried by the same hand which is holding the handle, in a locking position in which the locking means (17c) engage the container (10).

6. A device according to Claim 5, in which resilient means (21) which can maintain the locking means (17c) deactivated when the actuated arm (17a) of the lever is not stressed are provided.

7. A device according to Claim 5 or 6, in which the locking means comprise a tooth (17c) which, when the lever (17) is actuated, is against a side of the wall (13) of the container, preventing the projections (13a) from sliding in the corresponding grooves (15c).

8. A device according to any one of the preceding claims, in which the handle and holding part (14, 15) and the locking part (17) are made from an anti-static material.

9. A device according to any one of Claims 5 to 8, in which the longitudinal axis of the handle (14) is slightly inclined in the opposite direction to the open side of the container (10).

## Patentansprüche

1. Eine manuelle Haltevorrichtung für einen Behälter für Scheiben eines Halbleitermaterials, welche ein Handgriff- und Halte-Teil (14, 15) aufweist, das eine Einrichtung zum Koppeln (15, 15c) mit einer Wand (13) des Behälters (10) aufweist, dadurch gekennzeichnet, daß die Koppeleinrichtung (15, 15c) folgende Merkmale aufweist: ein Verschlußteil (17), das auf eine gelenkige Art und Weise mit dem Handgriff- und Halte-Teil (14, 15) verbunden ist und eine Verschlußeinrichtung (17c) und eine manuelle Betätigungseinrichtung (17a) aufweist, um die Verschlußeinrichtung (17c) in eine Ineingriffnahme mit dem Behälter (13) zu bringen, wobei es möglich ist, daß diese Betätigungseinrichtung (17a) mit der gleichen Hand betätigt wird, die den Handgriff (14) hält.

2. Eine Vorrichtung gemäß Anspruch 1 für einen Behälter (10), der eine im wesentlichen flache Wand (13) mit Vorsprüngen (13a) auf zwei gegenüberliegenden Seiten aufweist, wobei die Koppeleinrichtung (15, 15c) zwei gegenüberliegende Enden aufweist, welche Zurückhalteeinrichtungen (15b, 15c) aufweisen, die die Vorsprünge (13a) der Wand (13) des Behälters in Eingriff nehmen können.

3. Eine Vorrichtung gemäß Anspruch 2, bei der die Zurückhalteeinrichtungen (15b, 15c) jeweils eine Rille (15c) aufweisen, die einen Gleitsitz für den entsprechenden Vorsprung (13a) der Wand des Behälters bildet.

4. Eine Vorrichtung gemäß Anspruch 3, bei der die Zurückhalteeinrichtungen (15b, 15c) jeweils Sperreinrichtungen (16) aufweisen, welche das Gleiten der Vorsprünge (13a) in den jeweiligen Rillen (15c) beschränken.

5. Eine Vorrichtung gemäß einem beliebigen der Ansprüche 2 bis 4, bei der das Handgriff- und Halte-Teil (14, 15) aus einem Trägerelement (15), das die oben genannte Koppeleinrichtung (15c) aufweist, und aus einem stabartigen Handgriff (14) besteht, der einstückig mit dem Trägerelement (15) aufgebaut ist und aus einer mittleren Zone desselben vorsteht, und bei der die Verschlußeinrichtung (17c) an dem Ende von einem der zwei Arme (17b) eines Hebels (17), der auf einem Angelpunkt zwischen dem Handgriff (14) und dem Trägerelement (15) ruht, angeordnet ist, und bei der die Betätigungseinrichtung aus dem anderen (17a) der zwei Arme des Hebels (17) besteht, wobei sich dieser andere Arm (17a) zu dem Handgriff (14) hin erstreckt, derart, daß derselbe durch die gleiche Hand, die den Handgriff hält, in eine Verschlußstellung geführt werden kann, in der die Verschlußeinrichtung (17c) den Behälter (10) in Eingriff nimmt.

6. Eine Vorrichtung gemäß Anspruch 5, bei der eine elastische Einrichtung (21), die die Verschlußeinrichtung (17c) deaktiviert halten kann, wenn der betätigte Arm (17a) des Hebels nicht belastet ist, vorgesehen ist.

7. Eine Vorrichtung gemäß Anspruch 5 oder 6, bei der die Verschlußeinrichtung einen Zahn (17c) aufweist, der, wenn der Hebel (17) betätigt wird, gegen eine Seite der Wand (13) des Behälters liegt, wobei verhindert ist, daß die Vorsprünge (13a) in die entsprechenden Rillen (15c) gleiten.

8. Eine Vorrichtung gemäß einem beliebigen der vorhergehenden Ansprüche, bei der das Handgriff- und Halte-Teil (14, 15) und das Verschlußteil (17) aus einem antistatischen Material gebildet sind.

9. Eine Vorrichtung gemäß einem beliebigen der Ansprüche 5 bis 8, bei der die longitudinale Achse des Handgriffs (14) leicht in die entgegengesetzte Richtung bezüglich der offenen Seite des Behälters (10) geneigt ist.

## Revendications

1. Dispositif pour porter à la main un récipient de pastilles de matériau semi-conducteur, comprenant une poignée et un élément de soutien (14, 15) comportant un moyen d'assemblage (15, 15c) à une paroi (13) du récipient (10), caractérisé en ce que ledit moyen d'assemblage (15, 15c) comprend un élément de blocage (17) relié de manière articulée à la poignée et à l'élément de soutien (14, 15) et comprenant un moyen de blocage (17c) et des moyens d'actionnement à la main (17a) pour mettre le moyen de blocage (17c) en appui contre le récipient (13), ces moyens d'actionnement. (17a) pouvant être actionnés par la même main que celle qui tient la poignée (14).

2. Dispositif selon la revendication 1, destiné à un récipient (10) ayant une paroi sensiblement plane (13) comportant des protubérances (13a) sur deux côtés opposés, le moyen d'assemblage (15, 15c) ayant deux extrémités opposées comportant des moyens de retenue (15b, 15c) qui peuvent prendre appui contre les protubérances (13a) de la paroi (13) du récipient.

3. Dispositif selon la revendication 2, dans lequel chacun des moyens de retenue (15b, 15c) comprend une rainure (15c) qui constitue un siège de glissement de la protubérance correspondante (13a) de la paroi du récipient.

4. Dispositif selon la revendication 3, dans lequel chaque moyen de retenue (15b, 15c) comprend un moyen de blocage (16) qui limite le glissement des protubérances (13a) dans les rainures respectives (15c).

5. Dispositif selon l'une quelconque des revendications 2 à 4, dans lequel la poignée et l'élément de soutien (14, 15) consistent en un élément de support (15) comprenant le moyen d'assemblage mentionné plus haut (15c) et en une poignée (14) en forme de barre qui est monobloc avec l'élément de support (15) et est saillante sur une zone centrale de celui-ci, et dans lequel les moyens de blocage (17c) sont disposés à une extrémité de l'un de deux bras (17b) d'un levier (17) reposant sur un point d'appui situé entre la poignée (14) et l'élément de support (15), et dans lequel les moyens d'actionnement consistent en l'autre (17a) des deux bras du levier (17), cet autre bras (17a) étant orienté vers la poignée (14) de manière à être capable d'être porté par la même main que celle qui tient la poignée, à une position de blocage à laquelle les moyens de blocage (17c) sont en appui contre le récipient (10).

6. Dispositif selon la revendication 5, dans lequel est prévu un moyen élastique (21) qui peut maintenir le moyen de blocage (17c). hors d'action lorsque le bras actionné (17a) du levier n'est pas sous contrainte.

7. Dispositif selon la revendication 5 ou 6, dans lequel le moyen de blocage comprend une dent (17c) qui, lorsque le levier (17) est actionné, est placée contre un côté de la paroi (13) du récipient en empêchant les protubérances (13a) de glisser dans les rainures correspondantes (15c).

8. Dispositif selon l'une quelconque des revendications précédentes, dans lequel la poignée et l'élément de soutien (14, 15) ainsi que l'élément de blocage (17) sont réalisés en matière antistatique.

9. Dispositif selon l'une quelconque des revendications 5 à 8, dans lequel l'axe longitudinal de la poignée (14) est légèrement incliné dans le sens opposé à celui du côté ouvert du récipient (10).
